# FASCICULE DE BREVET EUROPEEN

(11) **EP 4 261 548 B1**
(45) Date de publication et mention de la délivrance du brevet: **21.08.2024**
(21) Numéro de dépôt: 23166770.0
(22) Date de dépôt: 05.04.2023
(51) Int. Cl.: G01R 15/18, G01R 35/00, G01R 35/02

(54) **PROCÉDÉ DE CALIBRATION, INSTALLATION DE CALIBRATION ET PROCÉDÉ D'ASSEMBLAGE D'UN CAPTEUR DE COURANT POUR APPAREILLAGE ÉLECTRIQUE DE COUPURE, CAPTEUR DE COURANT ASSOCIÉ**
KALIBRIERMETHODE, KALIBRIERINSTALLATION UND METHODE ZUR MONTAGE EINES STROMSENSORS FÜR SCHALTANLAGEN, ZUGEHÖRIGER STROMSENSOR
CALIBRATION METHOD, CALIBRATION INSTALLATION AND METHOD FOR ASSEMBLING A CURRENT SENSOR FOR SWITCHGEAR, ASSOCIATED CURRENT SENSOR

(30) Priorité: 14.04.2022 FR 2203454
(43) Date de publication de la demande: 18.10.2023
(73) Titulaire: HAGER-ELECTRO SAS, 67210 Obernai (FR)
(72) Inventeur: BETZY, Yoan, 67140 BARR (FR); HAMM, Thomas, 67170 OLWISHEIM (FR); STOCKER, Gilles, 67310 DAHLENHEIM (FR)
(74) Mandataire: Cabinet Nuss

(56) Documents cités:
- CN-A- 104 764 928
- CN-A- 106 645 861

## Description

La présente invention concerne le domaine des procédés de calibration d'un capteur de courant pour appareillage électrique de coupure, le domaine des installations de calibration d'un capteur de courant pour appareillage électrique de coupure, le domaine des procédés d'assemblage d'un capteur de courant pour appareillage électrique de coupure et le domaine des capteurs de courant pour appareillage électrique de coupure.

L'invention concerne les appareillages électriques de coupure dans le domaine tertiaire, tels que par exemple les disjoncteurs à air usuellement désignés par le sigle ACB ou les disjoncteurs à boîtier moulé.

De manière connue, la mesure du courant dans de tels disjoncteurs est réalisée par le sous-ensemble capteur de courant qui est constitué de deux parties. La première partie est une bobine de Rogowski qui sert à mesurer le courant. La deuxième partie est un transformateur de courant qui sert, le cas échéant à alimenter les éléments électroniques de l'appareillage électrique de coupure, par exemple un disjoncteur à air.

En outre, la sensibilité de la bobine de Rogowski peut varier d'une bobine de Rogowski à l'autre notamment du fait de la non-répétabilité de fabrication de la bobine de Rogowski. En effet, la pièce plastique formant le support sur laquelle le fil de la bobine de Rogowski est enroulé et le fil de la bobine de Rogowski peuvent présenter d'infimes variations de dimensions. Par ailleurs, le disjoncteur qui intègre le capteur de courant présente une voie de courant qui n'est pas uniforme. Les variations de sensibilité de la bobine de Rogowski influent sur la mesure du courant du fait de la non-uniformité de la voie de courant ce qui n'est pas souhaitable. En effet, la voie de courant présente par exemple une forme de U ce qui créée un champ magnétique non uniforme et fait varier la sensibilité de bobine de Rogowski selon son positionnement relativement à la voie de courant du fait de la non-maîtrise des variations de dimensions. CN 106 645 861 A et CN 104 764 928 A divulguent la calibration d'un capteur de courant Rogowski.

La présente invention a pour but de pallier au moins l'un de ces inconvénients et également de proposer une solution permettant de limiter l'influence de la non-répétabilité de fabrication de la bobine de Rogowski sur la mesure de courant.

A cet effet, l'invention concerne un procédé de calibration d'un capteur de courant pour un appareillage électrique de coupure, ledit capteur de courant comprenant au moins un transformateur de courant et une bobine de Rogowski d'axe de rotation, le transformateur de courant comprenant au moins un circuit magnétique sur lequel est apte à être superposée la bobine de Rogowski de sorte à être apte à être traversé par un conducteur,

ledit procédé de calibration est caractérisé en ce qu'il comprend au moins :

une étape de mesure de la sensibilité de la bobine de Rogowski, lors de laquelle un courant est appliqué audit conducteur de sorte à générer un champ magnétique non-uniforme et une mesure de tension en sortie de la bobine de Rogowski est effectuée en fonction de la position de la bobine de Rogowski relativement à la position du circuit magnétique autour de l'axe de rotation,

une étape de sélection de la position de la bobine de Rogowski, lors de laquelle une position dite sélectionnée de la bobine de Rogowski relativement à ladite position du circuit magnétique autour de l'axe de rotation est sélectionnée en fonction des mesures de sensibilité réalisées lors de ladite étape de mesure de la sensibilité de la bobine de Rogowski, de sorte qu'à la position dite sélectionnée, la sensibilité soit égale à une sensibilité cible prédéterminée.

L'invention concerne également une installation de calibration d'un capteur de courant pour un appareillage électrique de coupure, ledit capteur de courant comprenant au moins un transformateur de courant ou un transformateur de courant de référence et une bobine de Rogowski d'axe de rotation, le transformateur de courant comprenant au moins un circuit magnétique ou le transformateur de courant de référence comprenant au moins un circuit magnétique de référence, ledit un circuit magnétique ou circuit magnétique de référence sur lequel est apte à être superposée la bobine de Rogowski de sorte à être apte à être traversé par un conducteur, et pour la mise en oeuvre du procédé de calibration selon l'invention,

ladite installation est caractérisée en ce qu'elle comprend au moins :

un élément rotatif agencé pour mettre en rotation au moins la bobine de Rogowski ou au moins le circuit magnétique ou le circuit magnétique de référence autour de l'axe de rotation,

un élément de blocage agencé pour bloquer la rotation autour de l'axe de rotation de la bobine de Rogowski ou du circuit magnétique ou du circuit magnétique de référence respectivement lors de la mise en rotation du circuit magnétique ou du circuit magnétique de référence ou lors de la mise en rotation de la bobine de Rogowski par ledit élément.

L'invention concerne également un capteur de courant pour un appareillage électrique de coupure, ledit capteur de courant comprenant au moins un transformateur de courant et une bobine de Rogowski d'axe de rotation, le transformateur de courant comprenant au moins un circuit magnétique sur lequel est apte à être superposée la bobine de Rogowski de sorte à être apte à être traversé par un conducteur,

ledit capteur de courant est caractérisé en ce qu'il comprend des moyens d'immobilisation agencés pour immobiliser la position dite sélectionnée de la bobine de Rogowski relativement à ladite position du circuit magnétique, laquelle étant sélectionnée à l'issue de ladite étape de sélection de la position de la bobine de Rogowski du procédé de calibration d'un capteur de courant pour un appareillage électrique de coupure selon l'invention.

L'invention concerne également un procédé d'assemblage d'un capteur de courant selon l'invention, comprenant au moins un boîtier comprenant une première coque et une deuxième coque, la première coque présentant une première zone de réception de forme complémentaire à celle au moins de la bobine de Rogowski recevant la bobine de Rogowski et la deuxième coque présentant une deuxième zone de réception de forme complémentaire à celle au moins du transformateur de courant recevant ledit transformateur de courant, ledit procédé d'assemblage est caractérisé en ce qu'il comprend au moins :

une première étape d'assemblage dudit sous-ensemble calibré, lors de laquelle ledit sous-ensemble calibré est assemblé avec la première coque,

une deuxième étape d'assemblage du transformateur de courant, lors de laquelle, le circuit magnétique du transformateur de courant est superposé sur ledit élément intercalaire,

une troisième étape d'assemblage d'une deuxième coque, lors de laquelle la deuxième coque est assemblée à la première coque de sorte à assembler le boîtier contenant le sous-ensemble calibré et le transformateur de courant.

L'invention sera mieux comprise, grâce à la description ci-après, qui se rapporte à plusieurs modes de réalisation préférés, donnés à titre d'exemples non limitatifs, et expliqués avec référence aux dessins schématiques annexés, dans lesquels :
[Fig. 1] la figure 1 représente une courbe de la tension en sortie de la bobine de Rogowski en fonction de la position de la bobine de Rogowski à un courant,
[Fig. 2] la figure 2 représente une vue en perspective du transformateur de courant et de la bobine de Rogowski d'un capteur de courant selon l'invention lors d'une étape d'immobilisation de la position dite sélectionnée de la bobine de Rogowski,
[Fig.3] la figure 3 représente une vue en perspective d'une partie du capteur de courant selon l'invention lors d'une première étape d'assemblage dudit sous-ensemble calibré,
[Fig.4] la figure 4 représente une vue en perspective d'une partie du capteur de courant selon l'invention à l'issue de la première étape d'assemblage dudit sous-ensemble calibré,
[Fig.5] la figure 5 représente une vue en perspective du capteur de courant selon l'invention lors de la deuxième étape d'assemblage du transformateur de courant,
[Fig.6] la figure 6 représente une vue en perspective du capteur de courant selon l'invention lors de la troisième étape d'assemblage d'une deuxième coque,
[Fig.7] la figure 7 représente une vue en perspective de dessous du capteur de courant selon l'invention à l'issue de la troisième étape d'assemblage d'une deuxième coque,
[Fig.8] la figure 8 représente une vue de côté du capteur de courant selon l'invention à l'issue de la troisième étape d'assemblage d'une deuxième coque,
[Fig.9] la figure 9 représente une vue de dessus du capteur de courant selon l'invention à l'issue de la troisième étape d'assemblage d'une deuxième coque,
[Fig.10] la figure 10 représente une vue de côté et en coupe du capteur de courant selon l'invention à l'issue de la troisième étape d'assemblage d'une deuxième coque,
[Fig.11] la figure 11 représente une vue de côté et en coupe du capteur de courant selon l'invention à l'issue de la troisième étape d'assemblage d'une deuxième coque qui est traversé par un conducteur en forme de U.

L'invention concerne un procédé de calibration d'un capteur de courant 1 pour un appareillage électrique de coupure, ledit capteur de courant 1 comprenant au moins un transformateur de courant 2 et une bobine de Rogowski 3 d'axe de rotation A1, le transformateur de courant 2 comprenant au moins un circuit magnétique 4 sur lequel est apte à être superposée la bobine de Rogowski 3 de sorte à être apte à être traversé par un conducteur L.

Conformément à l'invention, ledit procédé de calibration est caractérisé en ce qu'il comprend au moins :
- une étape de mesure de la sensibilité de la bobine de Rogowski 3, lors de laquelle un courant I est appliqué audit conducteur L de sorte à générer un champ magnétique non-uniforme et une mesure de tension en sortie de la bobine de Rogowski 3 est effectuée en fonction de la position P de la bobine de Rogowski 3 relativement à la position du circuit magnétique 4 autour de l'axe de rotation A1,
- une étape de sélection de la position P de la bobine de Rogowski 3, lors de laquelle une position dite sélectionnée PS de la bobine de Rogowski 3 relativement à ladite position du circuit magnétique 4 autour de l'axe de rotation A1 est sélectionnée en fonction des mesures de sensibilité réalisées lors de ladite étape de mesure de la sensibilité de la bobine de Rogowski 3, de sorte qu'à la position dite sélectionnée PS, la sensibilité soit égale à une sensibilité cible prédéterminée.

Avantageusement, le procédé de calibration selon l'invention permet de positionner angulairement la bobine de Rogowski 3 par rapport au transformateur de courant 2 dans une position, appelée position dite sélectionnée PS pour laquelle la sensibilité est égale à une sensibilité cible prédéterminée. De préférence, cette sensibilité cible prédéterminée correspond à la sensibilité d'une bobine théorique idéale. Cette manière de procéder permet de limiter l'influence de la non-répétabilité de fabrication de la bobine de Rogowski 3 sur la mesure de courant réalisée par le capteur de courant 1 notamment lorsqu'il est intégré dans un appareillage électrique de coupure ayant une voie de courant qui n'est pas uniforme, c'est-à-dire qui peut générer un champ magnétique non uniforme lorsqu'il est traversé par un courant I.

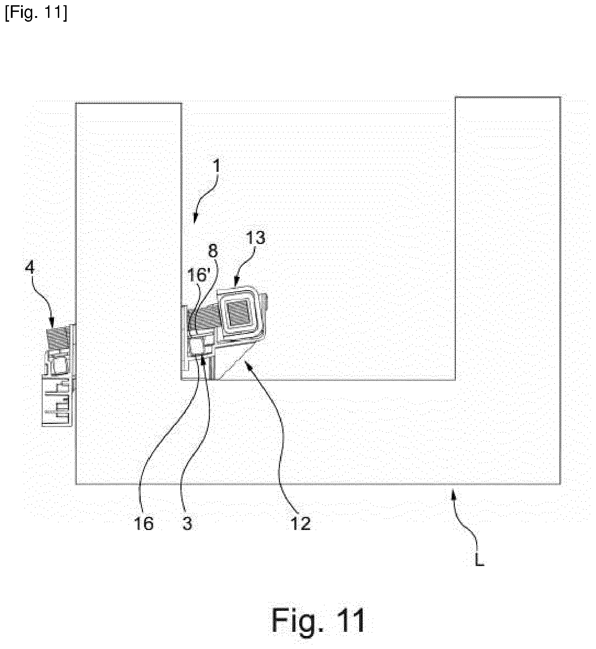

De préférence, le conducteur L présente une forme de U comme l'illustre la figure 11. Le conducteur L ne présente par une forme linéaire ou de barreau.

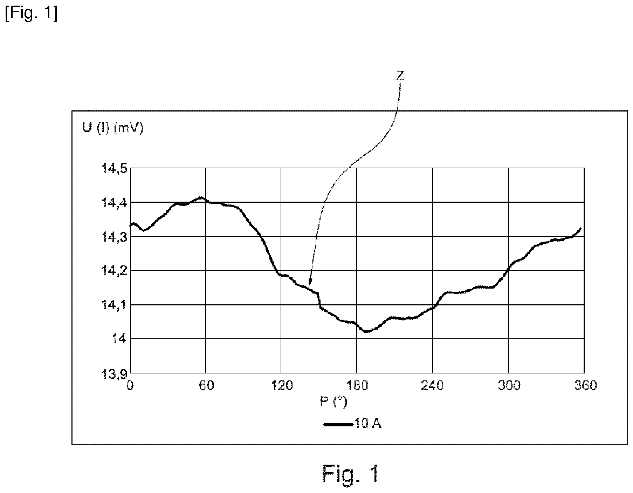

Comme l'illustre la figure 1, ladite étape de mesure de la sensibilité de la bobine de Rogowski 3 permet d'obtenir une courbe Z de la tension U en sortie de la bobine de Rogowski 3 en fonction de la position P de la bobine de Rogowski 3 à un courant I.

De préférence, le procédé de calibration d'un capteur de courant 1 pour un appareillage électrique de coupure peut comprendre en outre une étape d'immobilisation de la position dite sélectionnée PS de la bobine de Rogowski 3, lors de laquelle la position dite sélectionnée PS de la bobine de Rogowski 3, laquelle étant sélectionnée à l'issue de ladite étape de sélection de la position P de la bobine de Rogowski 3, est immobilisée par des moyens d'immobilisation 5 relativement à ladite position du circuit magnétique 4.

Avantageusement, l'étape d'immobilisation permet de figer la position dite sélectionnée PS de la bobine de Rogowski 3 vis-à-vis du transformateur de courant 2. Cette immobilisation par les moyens d'immobilisation peut être directe ou indirecte.

Les moyens d'immobilisation 5 peuvent comprendre seuls ou en combinaison des moyens de collage, tels que de la colle ou un adhésif double face, d'autres moyens équivalents de fixation ou d'assemblage peuvent être envisagés utilisant notamment des pièces supplémentaires, des moyens de repérage ou de marquage de la position dite sélectionnée PS, tels qu'un repère ou un symbole.

De préférence, lors de ladite étape de mesure de la sensibilité de la bobine de Rogowski 3, la bobine de Rogowski 3 est mise en rotation autour de l'axe de rotation A1 par un élément rotatif relativement au circuit magnétique 4 du transformateur de courant 2 ou à un circuit magnétique de référence d'un transformateur de courant de référence qui est fixe ou le circuit magnétique 4 ou le circuit magnétique de référence est mis en rotation autour de l'axe de rotation A1 par ledit élément rotatif relativement à la bobine de Rogowski 3 qui est fixe.

On entend par transformateur de courant de référence (non représenté), un transformateur de courant comprenant un circuit magnétique de référence (non représenté) qui est spécifiquement dédié au procédé de calibration selon l'invention. Le transformateur de courant de référence diffère du transformateur de courant 2 qui lui fait partie du capteur de courant 1 selon l'invention.

De préférence dans ce cas, lors de ladite étape de mesure de la sensibilité de la bobine de Rogowski 3, la mesure de tension U en sortie de la bobine de Rogowski 3 et la mise en rotation autour de l'axe de rotation A1 de la bobine de Rogowski 3 ou du circuit magnétique 4 ou du circuit magnétique de référence sont réalisées simultanément.

Avantageusement, cette simultanéité permet de rendre la solution industrialisable, puisqu'il est possible d'atteindre un temps de cycles permettant de mettre en oeuvre le procédé de calibration selon l'invention sur la totalité d'un ensemble de capteurs de courant 1 à calibrer.

La mesure de tension U peut être réalisée en même temps que la mise en rotation. De manière alternative, la mesure de tension U peut être réalisée à une ou plusieurs positions statiques, dans ce cas la mise en rotation est effectuée en l'absence de mesure de tension U, puis lorsqu'une position souhaitée est atteinte la mesure de la tension U est effectuée à cette position souhaitée sans mise en rotation et ainsi de suite.

Préférentiellement, ladite étape de mesure de la sensibilité de la bobine de Rogowski 3 est réalisée pour des positions P angulaires de la bobine de Rogowski 3 relativement à une position de référence du circuit magnétique 4 qui sont comprises entre 0 degré et 360 degrés.

De préférence, l'invention concerne également une installation de calibration d'un capteur de courant 1 pour un appareillage électrique de coupure, ledit capteur de courant 1 comprenant au moins un transformateur de courant 2 ou un transformateur de courant de référence et une bobine de Rogowski 3 d'axe de rotation A1, le transformateur de courant 2 comprenant au moins un circuit magnétique 4 ou le transformateur de courant de référence comprenant au moins un circuit magnétique de référence, ledit circuit magnétique 4 ou ledit circuit magnétique de référence sur lequel est apte à être superposée la bobine de Rogowski 3 de sorte à être apte à être traversé par un conducteur L, et pour la mise en oeuvre du procédé de calibration selon l'invention.

Conformément à l'invention ladite installation est caractérisée en ce qu'elle comprend au moins :
un élément rotatif (non représenté) agencé pour mettre en rotation au moins la bobine de Rogowski 3 ou au moins le circuit magnétique 4 ou le circuit magnétique de référence autour de l'axe de rotation A1,
un élément de blocage 7 agencé pour bloquer la rotation autour de l'axe de rotation A1 de la bobine de Rogowski 3 ou du circuit magnétique 4 ou du circuit magnétique de référence respectivement lors de la mise en rotation du circuit magnétique 4 ou du circuit magnétique de référence ou lors de la mise en rotation de la bobine de Rogowski 3 par ledit élément rotatif.

De préférence, ledit élément rotatif est un platine de rotation. Ledit élément rotatif peut comprendre par exemple un moteur (non représenté) et un support dont la forme permet de recevoir et/ou épouse la forme de la bobine de Rogowski 3 ou celle du circuit magnétique 4 ou celle du circuit magnétique de référence.

De préférence, ledit élément de blocage 7 consiste en des moyens d'exercer une force d'appui sur la bobine de Rogowski 3 de préférence dans une direction sensiblement perpendiculaire à l'axe de rotation A1. L'élément de blocage peut être une pince ou un moyen de serrage ou similaire.

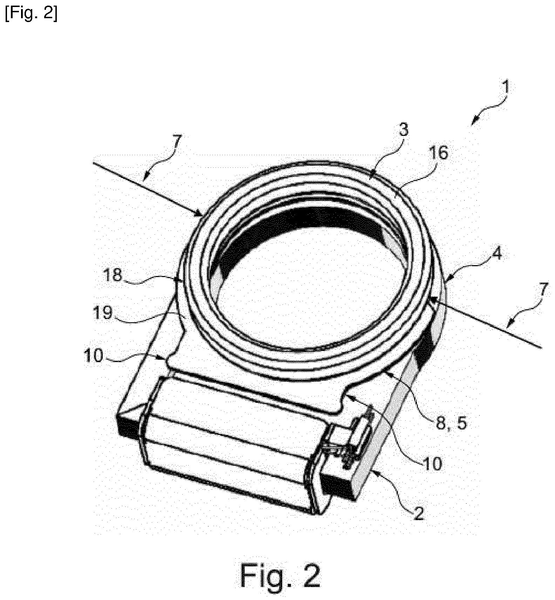

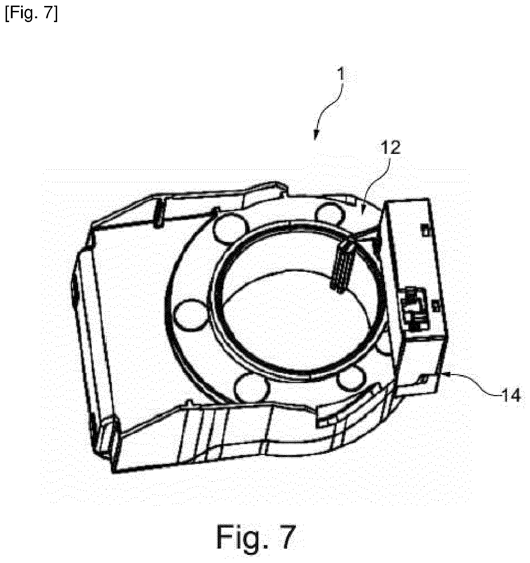

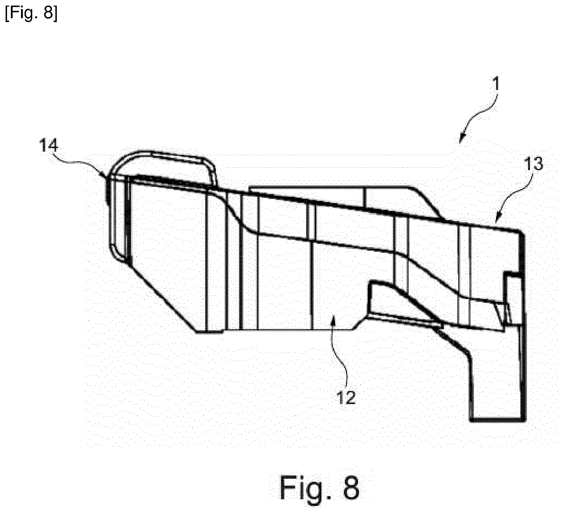

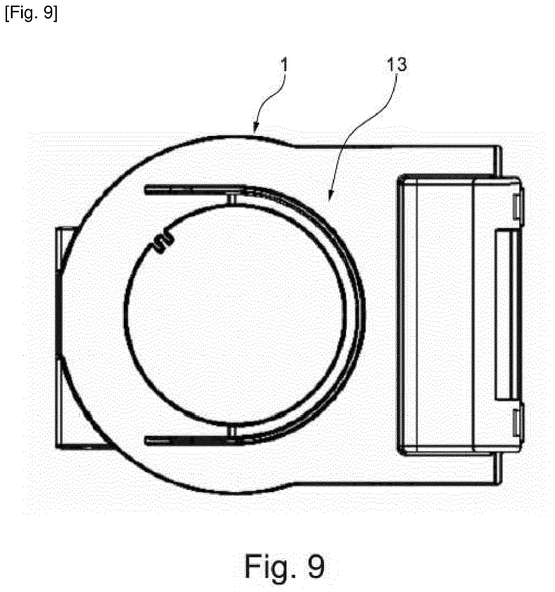

L'invention concerne également un capteur de courant 1 comme l'illustrent notamment les figures 2 et 6 à 11. Ledit capteur de courant 1 comprend au moins le transformateur de courant 2 et la bobine de Rogowski 3 d'axe de rotation A1. Le transformateur de courant 2 comprend au moins le circuit magnétique 4 sur lequel est apte à être superposée la bobine de Rogowski 3 de sorte à être apte à être traversé par un conducteur L.

Conformément à l'invention ledit capteur de courant 1 est caractérisé en ce qu'il comprend des moyens d'immobilisation 5 agencés pour immobiliser la position dite sélectionnée PS de la bobine de Rogowski 3 relativement à ladite position du circuit magnétique 4, laquelle étant sélectionnée à l'issue de ladite étape de sélection de la position P de la bobine de Rogowski 3 du procédé de calibration d'un capteur de courant 1 pour un appareillage électrique de coupure selon l'invention et tel que décrit précédemment.

Les moyens d'immobilisation 5 permettent d'identifier et/ou de figer la position dite sélectionnée PS de la bobine de Rogowski 3 relativement à ladite position du circuit magnétique 4. Ces moyens d'immobilisation 5 peuvent comprendre des moyens de collage, tels que de la colle ou un adhésif double face, d'autres moyens équivalents de fixation ou d'assemblage peuvent être envisagés utilisant notamment des pièces supplémentaires.

La bobine de Rogowski 3 comprend un tore amagnétique autour duquel est enroulé un fil.

De préférence et selon une première variante non illustrée de l'invention, le capteur de courant 1 comprend des moyens de collage ou des moyens équivalents de fixation ou d'assemblage situés entre ledit circuit magnétique 4 et la bobine de Rogowski 3, pour fixer la bobine de Rogowski 3 selon la position dite sélectionnée PS sur le circuit magnétique 4 du transformateur de courant 2.

Dans ce cas, les moyens d'immobilisation 5 comprennent au moins les moyens de collage ou les moyens équivalents de fixation ou d'assemblage et l'immobilisation est directe. En effet, la bobine de Rogowski 3 est collée ou fixée ou assemblée sur le circuit magnétique 4 selon la position dite sélectionnée PS.

De préférence et selon une deuxième variante non illustrée de l'invention, le capteur de courant 1 comprend un boîtier comprenant une première coque et une deuxième coque, la première coque présentant une première zone de réception de forme complémentaire à celle au moins de la bobine de Rogowski 3 recevant la bobine de Rogowski 3 et la deuxième coque présentant une deuxième zone de réception de forme complémentaire à celle au moins du transformateur de courant 2 recevant ledit transformateur de courant 2 et comprend des moyens de collage ou des moyens équivalents de fixation ou d'assemblage situés entre la bobine de Rogowski 3 et la deuxième coque, pour fixer la bobine de Rogowski 3 selon la position dite sélectionnée PS relativement au circuit magnétique 4 du transformateur de courant 2.

Dans ce cas, les moyens d'immobilisation 5 comprennent au moins les moyens de collage ou les moyens équivalents de fixation ou d'assemblage et l'immobilisation est indirecte, car elle est réalisée par l'intermédiaire de la deuxième coque du boîtier. En effet, la bobine de Rogowski 3 est superposée directement sur le circuit magnétique 4 selon la position dite sélectionnée PS et est collée ou fixée ou assemblée à la deuxième coque.

De préférence et selon une troisième variante non illustrée, le capteur de courant 1 comprend un boîtier comprenant une première coque et une deuxième coque, la première coque présentant une première zone de réception de forme complémentaire à celle au moins de la bobine de Rogowski 3 recevant la bobine de Rogowski et la deuxième coque présentant une deuxième zone de réception de forme complémentaire à celle au moins du transformateur de courant 2 recevant ledit transformateur de courant 2 et comprend des moyens de collage ou des moyens équivalents de fixation ou d'assemblage situés entre la bobine de Rogowski 3 et la première coque, pour fixer la bobine de Rogowski 3 selon la position dite sélectionnée PS relativement au circuit magnétique 4 du transformateur de courant 2.

Dans ce cas, les moyens d'immobilisation 5 comprennent au moins les moyens de collage ou les moyens équivalents de fixation ou d'assemblage et l'immobilisation est indirecte, car elle est réalisée par l'intermédiaire de la première coque du boîtier. En effet, la bobine de Rogowski 3 est superposée directement sur le circuit magnétique 4 selon la position dite sélectionnée PS et est collée ou fixée ou assemblée à la première coque.

De préférence et selon la quatrième variante de réalisation illustrée dans les figures 2 à 11, le capteur de courant 1 comprend un élément intercalaire 8, agencé pour être disposé entre ledit circuit magnétique 4 et la bobine de Rogowski 3, sur lequel est fixée la bobine de Rogowski 3 selon la position dite sélectionnée PS par des moyens de fixation 9 et ledit élément intercalaire 8 comprend au moins un organe de détrompage 10 pour l'assemblage au moins avec ledit circuit magnétique 4 du transformateur de courant 2 et/ou avec la première coque 12, ledit élément intercalaire 8 fixé à la bobine de Rogowski 3 formant un sous-ensemble calibré 11.

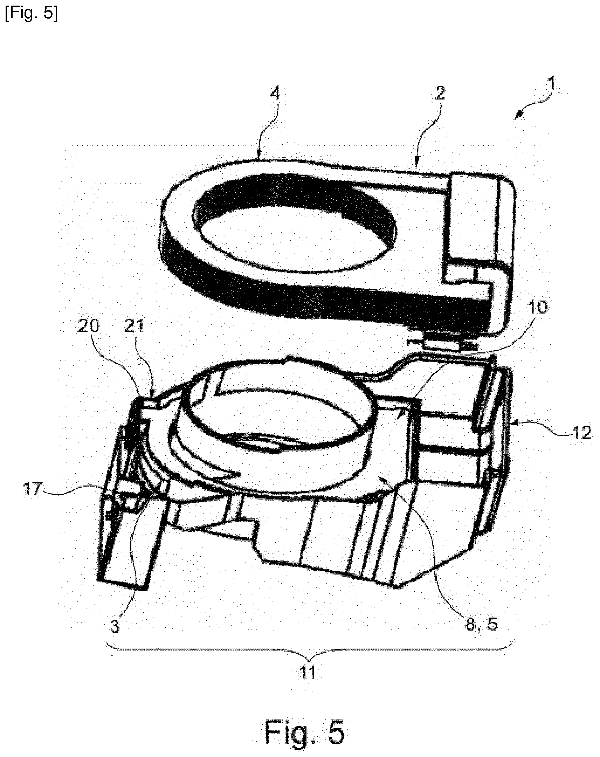

Dans ce cas, les moyens d'immobilisation 5 comprennent au moins ledit élément intercalaire 8 et les moyens de fixation 9 et l'immobilisation est indirecte, car elle est réalisée par l'intermédiaire de l'élément intercalaire 8. En effet, l'élément intercalaire 8 est intercalé entre la bobine de Rogowski 3 et le circuit magnétique 4. La bobine de Rogowski 3 est donc superposée directement sur l'élément intercalaire 8 selon la position dite sélectionnée PS et est collée ou fixée ou assemblée sur celui-ci. Ledit au moins un organe de détrompage 10, 21 permet d'effectuer l'assemblage de l'élément intercalaire 8 avec ledit circuit magnétique 4 pour que la bobine de Rogowski 3 soit disposée relativement à ladite position du circuit magnétique 4 dans la position dite sélectionnée PS. Ledit élément intercalaire 8 peut se présenter sous la forme d'une pièce plane pourvue d'une portion annulaire 18 comprenant une face de réception 19 qui présente des dimensions et une forme permettant de recevoir la bobine de Rogowski 3, comme l'illustre la figure 5. Ledit élément intercalaire 8 est de préférence en carton ou équivalent. La bobine de Rogowski 3 est de préférence collée ou fixée ou assemblée sur la face de réception 19 par les moyens de fixation 9.

Selon une possibilité de la quatrième variante de réalisation illustrée dans les figures 2 à 11, le capteur de courant 1 peut comprendre un boîtier 14 qui contient au moins le transformateur de courant 2 et la bobine de Rogowski 3. Ce boîtier 14 contient l'élément intercalaire 8. De préférence, le boîtier 14 comprend une première coque 12 et une deuxième coque 13. La première coque 12 présente de préférence une première zone de réception 15 de forme complémentaire à celle au moins de la bobine de Rogowski 3 et du transformateur de courant 2. La deuxième coque 13 présente de préférence une deuxième zone de réception (non visible) de forme complémentaire à celle au moins du transformateur de courant 2. De préférence, la première coque 12 et la deuxième coque 13 sont en plastique.

Ledit élément intercalaire 8 comprend au moins un organe de détrompage 10, 20 qui est prévu notamment pour coopérer avec une portion complémentaire 21, 10' de la première zone de réception 15 de la première coque 12 afin de faciliter le positionnement du sous-ensemble calibré 11 dans la première coque 12.

Un organe de détrompage 10, 21 peut comprendre au moins une languette qui s'insère dans une portion complémentaire 21, 10' de la première zone de réception 15 de la première coque 12. Dans l'exemple représenté, l'élément intercalaire 8 comprend trois languettes. De manière alternative et selon une possibilité non illustrée, l'organe de détrompage peut comprendre au moins un trou qui s'insère dans un plot saillant de la première zone de réception 15.

La première coque 12 comprend de préférence une zone de raccordement 17 de la sortie des deux fils de la bobine de Rogowski 3.

De préférence, les deux fils de la bobine de Rogowski 3 sont torsadés pour immuniser la bobine de Rogowski 3 aux perturbations électriques et/ou magnétiques.

La longueur de fils présente de préférence une longueur suffisante pour permettre le positionnement à l'extrême opposé soit à 180 degrés de la zone de raccordement 17.

Avantageusement, cette configuration permet que la sortie des deux fils de la bobine de Rogowski 3 puisse se retrouver dans toutes les positions P de la bobine de Rogowski 3 possibles et de préférence entre 0 degré et 360 degrés.

Préférentiellement, la bobine de Rogowski 3 est polarisée. Cette polarité est déterminée par le procédé de bobinage de la bobine de Rogowski 3. Un des deux fils est plus court pour ne pas perdre cette information de polarité.

L'invention concerne également un appareillage électrique de coupure comprenant au moins un capteur de courant 1 selon l'invention.

De préférence, ledit appareillage électrique de coupure (non représenté) est un disjoncteur, par exemple du type disjoncteur à air ou ACB (Air Circuit Breaker) ou un MCCB (Molded Case Circuit Breaker).

La bobine de Rogowski 3 du capteur de courant 1 permet de mesurer le courant d'une voie de courant (non représentée) que comprend l'appareillage électrique de coupure.

De préférence, cette voie de courant présente une forme de U et n'est pas linéaire ou en forme de barreau.

Le transformateur de courant 2 du capteur de courant permet par exemple d'alimenter une unité électronique (non représentée) que comprend l'appareillage électrique de coupure.

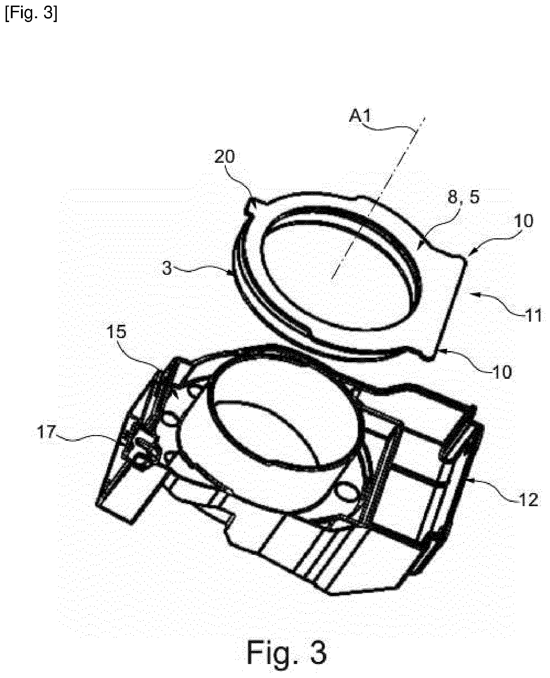

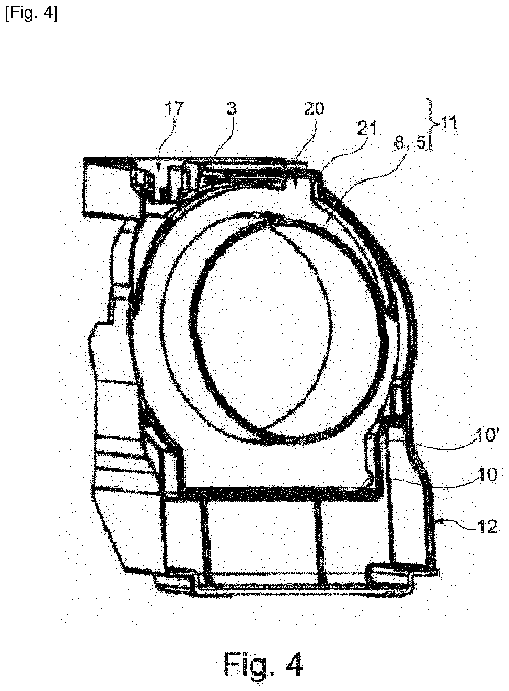

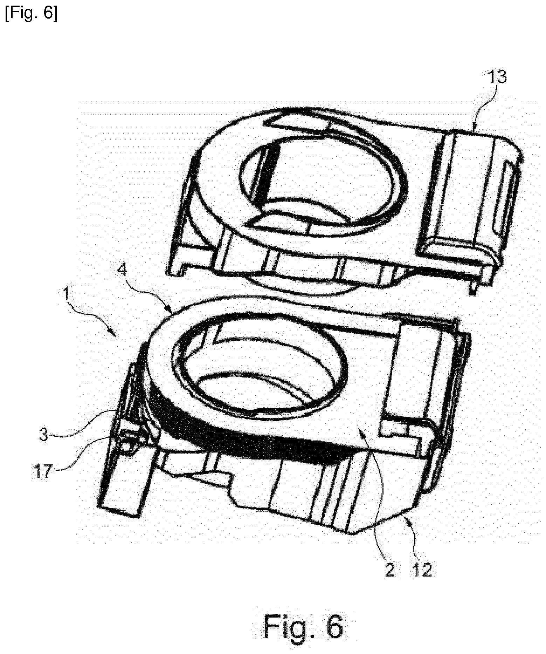

L'invention concerne également un procédé d'assemblage d'un capteur de courant 1 selon la quatrième variante de réalisation pour un appareillage électrique de coupure comprenant au moins un boîtier 14 comprenant une première coque 12 et une deuxième coque 13, la première coque 12 présentant une première zone de réception 15 de forme complémentaire à celle au moins de la bobine de Rogowski 3 recevant la bobine de Rogowski 3 et la deuxième coque 13 présentant une deuxième zone de réception de forme complémentaire à celle au moins du transformateur de courant 2 recevant ledit transformateur de courant 2, ledit procédé d'assemblage est caractérisé en ce qu'il comprend au moins :
une première étape d'assemblage dudit sous-ensemble calibré 11, lors de laquelle ledit sous-ensemble calibré 11 est assemblé avec une première coque 12 (figures 3 et 4),
une deuxième étape d'assemblage du transformateur de courant 2, lors de laquelle, le circuit magnétique 4 du transformateur de courant 2 est superposé sur ledit élément intercalaire 8 (figure 5),
une troisième étape d'assemblage d'une deuxième coque 13, lors de laquelle la deuxième coque 13 est assemblée à la première coque 12 de sorte à former un boîtier 14 contenant le sous-ensemble calibré 11 et le transformateur de courant 2 (figures 6 à 10).

De préférence, le procédé d'assemblage comprend une étape d'orientation de la sortie des deux fils de la bobine de Rogowski 3, qui est réalisée entre la première étape et la deuxième étape, lors de laquelle la sortie des deux fils de la bobine de Rogowski 3 est orientée en face de la zone de raccordement 17.

Préférentiellement, la bobine de Rogowski 3 étant polarisée, lors de l'étape d'orientation, le surplus d'un des deux fils n'est pas coupé pour conserver l'information sur la polarité.

Selon un exemple de mise en oeuvre de l'invention le procédé de calibration selon l'invention est d'abord mis en oeuvre, puis le procédé d'assemblage est mis en oeuvre. On obtient avantageusement le capteur de courant 1 selon l'invention représenté notamment aux figures 6 à 11.

Ainsi selon un exemple pour la mise en oeuvre du procédé de calibration, dans un premier temps le transformateur de courant 2, l'élément intercalaire 8 et la bobine de Rogowski 3 sont mis à disposition et placés sur une installation selon l'invention. De préférence, la bobine de Rogowski 3 est immobilisée par l'élément de blocage 7 de cette installation, tandis que le circuit magnétique 4 du transformateur de courant 2 est disposé sur l'élément rotatif de cette installation. Plus particulièrement, l'élément intercalaire 8 est de préférence assemblé avec ledit circuit magnétique 4 du transformateur de courant 2 par des moyens d'assemblage ou posé sur ledit circuit magnétique 4 du transformateur de courant 2 de préférence à l'aide dudit au moins un organe de détrompage 10, 21.

Dans un second temps, ladite étape de mesure de la sensibilité de la bobine de Rogowski 3 est réalisée. Ainsi, le circuit magnétique 4 est mis en rotation autour de l'axe de rotation A1 par ledit élément rotatif relativement à la bobine de Rogowski 3 qui est fixe et la mesure de tension U en sortie de la bobine de Rogowski 3 est réalisée.

Dans un troisième temps, l'étape de sélection de la position P de la bobine de Rogowski 3 est réalisée ce qui permet d'obtenir la valeur de la position dite sélectionnée PS.

Dans un quatrième temps et comme l'illustre la figure 5, l'étape d'immobilisation de la position dite sélectionnée PS de la bobine de Rogowski 3 est mise en oeuvre lors de laquelle la position dite sélectionnée PS de la bobine de Rogowski 3 est immobilisée par des moyens d'immobilisation 5 relativement à ladite position du circuit magnétique 4. Plus particulièrement, la bobine de Rogowski 3 peut être fixée sur l'élément intercalaire 8 selon la position dite sélectionnée PS par des moyens de fixation 9, qui peuvent consister en des moyens de collage, tels que de la colle ou un adhésif double face, d'autres moyens équivalents peuvent être envisagés par exemple des moyens d'assemblage. L'élément intercalaire 8 est ainsi disposé entre ledit circuit magnétique 4 et la bobine de Rogowski 3. On obtient avantageusement un sous-ensemble calibré 11 comprenant ledit élément intercalaire 8 fixé à la bobine de Rogowski 3.

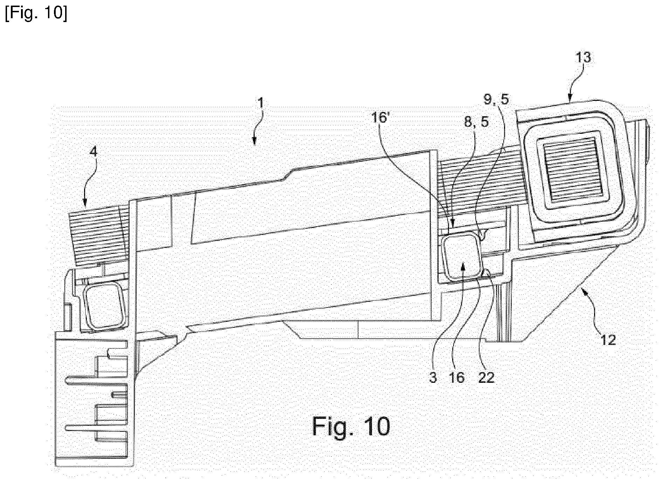

Ainsi selon un exemple pour la mise en oeuvre du procédé d'assemblage illustré aux figures 3 à 10, dans un premier temps la première étape d'assemblage dudit sous-ensemble calibré 11 est réalisée, comme le montrent les figures 3 et 4. En pratique le sous-ensemble calibré 11 est disposé dans la première coque 12 qui présente une première zone de réception 15 de forme complémentaire à celle du sous-ensemble calibré 11. Ledit au moins un organe de détrompage 10, 20 et la portion complémentaire 10', 21 de la première zone de réception 15 sont assemblés pour faciliter le positionnement dans la première coque 12. Des moyens de fixation 22, tels que des moyens de collage, par exemple de la colle ou un adhésif double face ou d'autres moyens équivalents peuvent être envisagés, sont de préférence utilisés entre la première zone de réception 15 de la première coque 12 et une face 16 de la bobine de Rogowski opposée à une face 16' sur laquelle est fixé l'élément intercalaire 8 pour maintenir le sous-ensemble calibré 11 dans la première coque 12, comme cela est visible sur la figure 10.

Dans un second temps et comme l'illustre la figure 5, la deuxième étape d'assemblage du transformateur de courant 2 est réalisée. De cette manière, la bobine de Rogowski 3 est immobilisée dans la position dite sélectionnée PS vis-à-vis du transformateur de courant 2.

Dans un troisième temps et comme l'illustrent les figures 6 à 10, la troisième étape d'assemblage d'une deuxième coque 13 est réalisée pour fermer le boîtier 14 à l'aide de la deuxième coque 13.

Bien entendu, l'invention n'est pas limitée aux modes de réalisations décrits et représentés aux dessins annexés. Des modifications restent possibles, notamment du point de vue de la constitution des divers éléments, sans sortir pour autant du domaine de protection de l'invention.

## Revendications

1. Procédé de calibration d'un capteur de courant (1) pour un appareillage électrique de coupure, ledit capteur de courant (1) comprenant au moins un transformateur de courant (2) et une bobine de Rogowski (3) d'axe de rotation (A1), le transformateur de courant (2) comprenant au moins un circuit magnétique (4) sur lequel est apte à être superposée la bobine de Rogowski (3) de sorte à être apte à être traversé par un conducteur (L), ledit procédé de calibration est **caractérisé en ce qu'**il comprend au moins :
- une étape de mesure de la sensibilité de la bobine de Rogowski (3), lors de laquelle un courant (I) est appliqué audit conducteur (L) de sorte à générer un champ magnétique non-uniforme et une mesure de tension en sortie de la bobine de Rogowski (3) est effectuée en fonction de la position (P) de la bobine de Rogowski (3) relativement à la position du circuit magnétique (4) autour de l'axe de rotation (A1),
- une étape de sélection de la position (P) de la bobine de Rogowski (3), lors de laquelle une position dite sélectionnée (PS) de la bobine de Rogowski (3) relativement à ladite position du circuit magnétique (4) autour de l'axe de rotation (A1) est sélectionnée en fonction des mesures de sensibilité réalisées lors de ladite étape de mesure de la sensibilité de la bobine de Rogowski (3), de sorte qu'à la position dite sélectionnée (PS), la sensibilité soit égale à une sensibilité cible prédéterminée.

2. Procédé de calibration d'un capteur de courant (1) pour un appareillage électrique de coupure selon la revendication 1, **caractérisé en ce qu'**il comprend en outre une étape d'immobilisation de la position dite sélectionnée (PS) de la bobine de Rogowski (3), lors de laquelle la position dite sélectionnée (PS) de la bobine de Rogowski (3), laquelle étant sélectionnée à l'issue de ladite étape de sélection de la position (P) de la bobine de Rogowski (3), est immobilisée par des moyens d'immobilisation (5) relativement à ladite position du circuit magnétique (4).

3. Procédé de calibration d'un capteur de courant (1) pour un appareillage électrique de coupure selon l'une quelconque des revendications 1 à 2, **caractérisé en ce que** lors de ladite étape de mesure de la sensibilité de la bobine de Rogowski (3), la bobine de Rogowski (3) est mise en rotation autour de l'axe de rotation (A1) par un élément rotatif relativement au circuit magnétique (4) du transformateur de courant (2) ou à un circuit magnétique de référence d'un transformateur de courant de référence qui est fixe ou le circuit magnétique (4) ou le circuit magnétique de référence est mis en rotation autour de l'axe de rotation (A1) par ledit élément rotatif (6) relativement à la bobine de Rogowski (3) qui est fixe.

4. Procédé de calibration d'un capteur de courant (1) pour un appareillage électrique de coupure selon la revendication 3, **caractérisé en ce que** lors de ladite étape de mesure de la sensibilité de la bobine de Rogowski (3), la mesure de tension (U) en sortie de la bobine de Rogowski (3) et la mise en rotation autour de l'axe de rotation (A1) de la bobine de Rogowski (3) ou du circuit magnétique (4) ou du circuit magnétique de référence sont réalisées simultanément.

5. Procédé de calibration d'un capteur de courant (1) pour un appareillage électrique de coupure selon l'une quelconque des revendications 1 à 4, **caractérisé en ce que** ladite étape de mesure de la sensibilité de la bobine de Rogowski (3) est réalisée pour des positions (P) angulaires de la bobine de Rogowski (3) relativement à une position de référence du circuit magnétique (4) qui sont comprises entre 0 degré et 360 degrés.

6. Installation de calibration d'un capteur de courant (1) pour un appareillage électrique de coupure, ledit capteur de courant (1) comprenant au moins un transformateur de courant (2) ou un transformateur de courant de référence et une bobine de Rogowski (3) d'axe de rotation (A1), le transformateur de courant (2) comprenant au moins un circuit magnétique (4) ou le transformateur de courant de référence comprenant au moins un circuit magnétique de référence, ledit un circuit magnétique (4) ou circuit magnétique de référence sur lequel est apte à être superposée la bobine de Rogowski (3) de sorte à être apte à être traversé par un conducteur (L), et pour la mise en oeuvre du procédé de calibration selon l'une quelconque des revendications 3 à 5,
ladite installation est **caractérisée en ce qu'**elle comprend au moins :
- un élément rotatif agencé pour mettre en rotation au moins la bobine de Rogowski (3) ou au moins le circuit magnétique (4) ou le circuit magnétique de référence autour de l'axe de rotation (A1),
- un élément de blocage (7) agencé pour bloquer la rotation autour de l'axe de rotation A1 de la bobine de Rogowski (3) ou du circuit magnétique (4) ou du circuit magnétique de référence respectivement lors de la mise en rotation du circuit magnétique (4) ou du circuit magnétique de référence ou lors de la mise en rotation de la bobine de Rogowski (3) par ledit élément rotatif (6).

7. Capteur de courant (1) pour un appareillage électrique de coupure, ledit capteur de courant (1) comprenant au moins un transformateur de courant (2) et une bobine de Rogowski (3) d'axe de rotation (A1), le transformateur de courant (2) comprenant au moins un circuit magnétique (4) sur lequel est apte à être superposée la bobine de Rogowski (3) de sorte à être apte à être traversé par un conducteur (L),
ledit capteur de courant (1) est **caractérisé en ce qu'**il comprend des moyens d'immobilisation (5) agencés pour immobiliser la position dite sélectionnée (PS) de la bobine de Rogowski (3) relativement à ladite position du circuit magnétique (4), laquelle étant sélectionnée à l'issue de ladite étape de sélection de la position (P) de la bobine de Rogowski (3) du procédé de calibration d'un capteur de courant (1) pour un appareillage électrique de coupure selon l'une quelconque des revendications 1 à 5.

8. Capteur de courant pour un appareillage électrique de coupure selon la revendication 7, **caractérisé en ce qu'**il comprend des moyens de collage ou des moyens équivalents de fixation ou d'assemblage situés entre ledit circuit magnétique (4) et la bobine de Rogowski (3), pour fixer la bobine de Rogowski (3) selon la position dite sélectionnée (PS) sur le circuit magnétique (4) du transformateur de courant (2).

9. Capteur de courant pour un appareillage électrique de coupure selon la revendication 7, **caractérisé en ce qu'**il comprend un boîtier comprenant une première coque et une deuxième coque, la première coque présentant une première zone de réception de forme complémentaire à celle au moins de la bobine de Rogowski (3) recevant la bobine de Rogowski (3) et la deuxième coque présentant une deuxième zone de réception de forme complémentaire à celle au moins du transformateur de courant (2) recevant ledit transformateur de courant (2) et **en ce qu'**il comprend des moyens de collage ou des moyens équivalents de fixation ou d'assemblage situés entre la bobine de Rogowski (3) et la deuxième coque pour fixer la bobine de Rogowski (3) selon la position dite sélectionnée (PS) relativement au circuit magnétique (4) du transformateur de courant (2).

10. Capteur de courant (1) pour un appareillage électrique de coupure selon la revendication 7, **caractérisé en ce qu'**il comprend un boîtier comprenant une première coque et une deuxième coque, la première coque présentant une première zone de réception de forme complémentaire à celle au moins de la bobine de Rogowski (3) recevant la bobine de Rogowski et la deuxième coque présentant une deuxième zone de réception de forme complémentaire à celle au moins du transformateur de courant (2) recevant ledit transformateur de courant (2) et **en ce qu'**il comprend des moyens de collage ou des moyens équivalents de fixation ou d'assemblage situés entre la bobine de Rogowski (3) et la première coque pour fixer la bobine de Rogowski (3) selon la position dite sélectionnée PS relativement au circuit magnétique (4) du transformateur de courant.

11. Capteur de courant (1) pour un appareillage électrique de coupure selon la revendication 7, **caractérisé en ce qu'**il comprend un élément intercalaire (8), agencé pour être disposé entre ledit circuit magnétique (4) et la bobine de Rogowski (3), sur lequel est fixée la bobine de Rogowski (3) selon la position dite sélectionnée (PS) par des moyens de fixation (9) et **en ce que** ledit élément intercalaire (8) comprend au moins un organe de détrompage (10, 21) pour l'assemblage au moins avec ledit circuit magnétique (4) du transformateur de courant (2), ledit élément intercalaire (8) fixé à la bobine de Rogowski (3) formant un sous-ensemble calibré (11).

12. Procédé d'assemblage d'un capteur de courant (1) pour un appareillage électrique de coupure selon la revendication 11, comprenant au moins un boîtier (14) comprenant une première coque (12) et une deuxième coque (13), la première coque (12) présentant une première zone de réception (15) de forme complémentaire à celle au moins de la bobine de Rogowski (3) recevant la bobine de Rogowski (3) et la deuxième coque (13) présentant une deuxième zone de réception de forme complémentaire à celle au moins du transformateur de courant (2) recevant ledit transformateur de courant (2), ledit procédé d'assemblage est **caractérisé en ce qu'**il comprend au moins :
- une première étape d'assemblage dudit sous-ensemble calibré (11), lors de laquelle ledit sous-ensemble calibré (11) est assemblé avec la première coque (12),
- une deuxième étape d'assemblage du transformateur de courant (2), lors de laquelle, le circuit magnétique (4) du transformateur de courant (2) est superposé sur ledit élément intercalaire (8),
- une troisième étape d'assemblage d'une deuxième coque (13), lors de laquelle la deuxième coque (13) est assemblée à la première coque (12) de sorte à assembler le boîtier (14) contenant le sous-ensemble calibré (11) et le transformateur de courant (2).

## Patentansprüche

1. Verfahren zur Kalibrierung eines Stromsensors (1) für ein elektrisches Abschaltgerät, wobei der Stromsensor (1) mindestens einen Stromwandler (2) und eine Rogowskispule (3) mit einer Drehachse (A1) enthält, wobei der Stromwandler (2) mindestens einen Magnetkreis (4) enthält, auf den die Rogowskispule (3) überlagert werden kann, um von einem Leiter (L) durchquert werden zu können,
wobei das Kalibrierungsverfahren **dadurch gekennzeichnet ist, dass** es mindestens enthält:
- einen Schritt der Messung der Empfindlichkeit der Rogowskispule (3), in dem ein Strom (I) an den Leiter (L) angelegt wird, um ein ungleichförmiges Magnetfeld zu erzeugen, und eine Spannungsmessung am Ausgang der Rogowskispule (3) abhängig von der Position (P) der Rogowskispule (3) bezüglich der Position des Magnetkreises (4) um die Drehachse (A1) herum ausgeführt wird,
- einen Schritt der Auswahl der Position (P) der Rogowskispule (3), in dem eine so genannte ausgewählte Position (PS) der Rogowskispule (3) bezüglich der Position des Magnetkreises (4) um die Drehachse (A1) abhängig von den Empfindlichkeitsmessungen ausgewählt wird, die im Schritt der Messung der Empfindlichkeit der Rogowskispule (3) durchgeführt werden, so dass in der so genannten ausgewählten Position (PS) die Empfindlichkeit gleich einer vorbestimmten Ziel-Empfindlichkeit ist.

2. Kalibrierungsverfahren eines Stromsensors (1) für ein elektrisches Abschaltgerät nach Anspruch 1, **dadurch gekennzeichnet, dass** es außerdem einen Schritt der Immobilisierung der so genannten ausgewählten Position (PS) der Rogowskispule (3) enthält, in dem die so genannte ausgewählte Position (PS) der Rogowskispule (3), die am Ende des Auswahlschritts der Position (P) der Rogowskispule (3) ausgewählt wird, durch Immobilisierungseinrichtungen (5) bezüglich der Position des Magnetkreises (4) immobilisiert wird.

3. Kalibrierungsverfahren eines Stromsensors (1) für ein elektrisches Abschaltgerät nach einem der Ansprüche 1 bis 2, **dadurch gekennzeichnet, dass** im Messschritt der Empfindlichkeit der Rogowskispule (3) die Rogowskispule (3) durch ein drehbares Element bezüglich des Magnetkreises (4) des Stromwandlers (2) oder eines Bezugs-Magnetkreises eines Bezugs-Stromwandlers, der ortsfest ist, um die Drehachse (A1) in Drehung versetzt wird, oder der Magnetkreis (4) oder der Bezugs-Magnetkreis durch das drehbare Element (6) bezüglich der Rogowskispule (3), die ortsfest ist, um die Drehachse (A1) in Drehung versetzt wird.

4. Kalibrierungsverfahren eines Stromsensors (1) für ein elektrisches Abschaltgerät nach Anspruch 3, **dadurch gekennzeichnet, dass** im Messschritt der Empfindlichkeit der Rogowskispule (3) die Spannungsmessung (U) am Ausgang der Rogowskispule (3) und die Drehung der Rogowskispule (3) oder des Magnetkreises (4) oder des Bezugs-Magnetkreises um die Drehachse (A1) gleichzeitig durchgeführt werden.

5. Kalibrierungsverfahren eines Stromsensors (1) für ein elektrisches Abschaltgerät nach einem der Ansprüche 1 bis 4, **dadurch gekennzeichnet, dass** der Messschritt der Empfindlichkeit der Rogowskispule (3) für Winkelpositionen (P) der Rogowskispule (3) bezüglich einer Bezugsposition des Magnetkreises (4) durchgeführt wird, die zwischen 0 Grad und 360 Grad liegen.

6. Kalibrierungsanlage eines Stromsensors (1) für ein elektrisches Abschaltgerät, wobei der Stromsensor (1) mindestens einen Stromwandler (2) oder einen Bezugs-Stromwandler und eine Rogowskispule (3) mit einer Drehachse (A1) enthält, wobei der Stromwandler (2) mindestens einen Magnetkreis (4) enthält oder der Bezugs-Stromwandler mindestens einen Bezugs-Magnetkreis enthält, den einen Magnetkreis (4) oder Bezugs-Magnetkreis, auf den die Rogowskispule (3) überlagert werden kann, um von einem Leiter (L) durchquert zu werden, und für die Durchführung des Kalibrierungsverfahrens nach einem der Ansprüche 3 bis 5,
die Anlage ist **dadurch gekennzeichnet, dass** sie mindestens enthält:
- ein drehbares Element, das eingerichtet ist, um mindestens die Rogowskispule (3) oder mindestens den Magnetkreis (4) oder den Bezugs-Magnetkreis um die Drehachse (A1) in Drehung zu versetzen,
- ein Blockierelement (7), das eingerichtet ist, um die Drehung der Rogowskispule (3) oder des Magnetkreises (4) oder des Bezugs-Magnetkreises um die Drehachse A1 beim Indrehungversetzen des Magnetkreises (4) bzw. des Bezugs-Magnetkreises oder beim Indrehungversetzen der Rogowskispule (3) durch das drehbare Element (6) zu blockieren.

7. Stromsensor (1) für ein elektrisches Abschaltgerät, wobei der Stromsensor (1) mindestens einen Stromwandler (2) und eine Rogowskispule (3) mit einer Drehachse (A1) enthält, wobei der Stromwandler (2) mindestens einen Magnetkreis (4) enthält, auf den die Rogowskispule (3) überlagert werden kann, um von einem Leiter (L) durchquert werden zu können,
der Stromsensor (1) ist **dadurch gekennzeichnet, dass** er Immobilisierungseinrichtungen (5) enthält, die eingerichtet sind, um die so genannte ausgewählte Position (PS) der Rogowskispule (3) bezüglich der Position des Magnetkreises (4) zu immobilisieren, die am Ende des Auswahlschritts der Position (P) der Rogowskispule (3) des Kalibrierungsverfahrens eines Stromsensors (1) für ein elektrisches Abschaltgerät nach einem der Ansprüche 1 bis 5 ausgewählt wird.

8. Stromsensor für ein elektrisches Abschaltgerät nach Anspruch 7, **dadurch gekennzeichnet, dass** er Klebeeinrichtungen oder äquivalente Befestigungs- oder Zusammenbaueinrichtungen enthält, die sich zwischen dem Magnetkreis (4) und der Rogowskispule (3) befinden, um die Rogowskispule (3) gemäß der so genannten ausgewählten Position (PS) auf dem Magnetkreis (4) des Stromwandlers (2) zu befestigen.

9. Stromsensor für ein elektrisches Abschaltgerät nach Anspruch 7, **dadurch gekennzeichnet, dass** er ein Gehäuse enthält, das eine erste Schale und eine zweite Schale enthält, wobei die erste Schale einen ersten Aufnahmebereich einer Form komplementär mindestens zu derjenigen der Rogowskispule (3) aufweist, der die Rogowskispule (3) aufnimmt, und die zweite Schale einen zweiten Aufnahmebereich einer Form komplementär zu mindestens derjenigen des Stromwandlers (2) aufweist, der den Stromwandler (2) aufnimmt, und dass er Klebeeinrichtungen oder äquivalente Befestigungs- oder Zusammenbaueinrichtungen enthält, die sich zwischen der Rogowskispule (3) und der zweiten Schale befinden, um die Rogowskispule (3) gemäß der so genannten ausgewählten Position (PS) bezüglich des Magnetkreises (4) des Stromwandlers (2) zu befestigen.

10. Stromsensor (1) für ein elektrisches Abschaltgerät nach Anspruch 7, **dadurch gekennzeichnet, dass** er ein Gehäuse enthält, das eine erste Schale und eine zweite Schale enthält, wobei die erste Schale einen ersten Aufnahmebereich einer Form komplementär zu mindestens derjenigen der Rogowskispule (3) aufweist, der die Rogowskispule aufnimmt, und die zweite Schale einen zweiten Aufnahmebereich einer Form komplementär zu mindestens derjenigen des Stromwandlers (2) aufweist, der den Stromwandler (2) aufnimmt, und dass er Klebeeinrichtungen oder äquivalente Befestigungs- oder Zusammenbaueinrichtungen enthält, die sich zwischen der Rogowskispule (3) und der ersten Schale befinden, um die Rogowskispule (3) gemäß der so genannten ausgewählten Position PS bezüglich des Magnetkreises (4) des Stromwandlers zu befestigen.

11. Stromsensor (1) für ein elektrisches Abschaltgerät nach Anspruch 7, **dadurch gekennzeichnet, dass** er ein Zwischenelement (8) enthält, das eingerichtet ist, um zwischen dem Magnetkreis (4) und der Rogowskispule (3) angeordnet zu werden, an dem die Rogowskispule (3) gemäß der so genannten ausgewählten Position (PS) durch Befestigungseinrichtungen (9) befestigt wird, und dass das Zwischenelement (8) mindestens eine Unverwechselbarkeitseinrichtung (10, 21) für den Zusammenbau mindestens mit dem Magnetkreis (4) des Stromwandlers (2) enthält, wobei das an der Rogowskispule (3) befestigte Zwischenelement (8) eine kalibrierte Untereinheit (11) bildet.

12. Verfahren zum Zusammenbau eines Stromsensors (1) für ein elektrisches Abschaltgerät nach Anspruch 11, der mindestens ein Gehäuse (14) enthält, das eine erste Schale (12) und eine zweite Schale (13) enthält, wobei die erste Schale (12) einen ersten Aufnahmebereich (15) einer Form komplementär zu mindestens derjenigen der Rogowskispule (3) aufweist, der die Rogowskispule (3) aufnimmt, und die zweite Schale (13) einen zweiten Aufnahmebereich einer Form komplementär mindestens zu derjenigen des Stromwandlers (2) aufweist, der den Stromwandler (2) aufnimmt, das Zusammenbauverfahren ist **dadurch gekennzeichnet, dass** es mindestens enthält:
- einen ersten Schritt des Zusammenbaus der kalibrierten Untereinheit (11), in dem die kalibrierte Untereinheit (11) mit der ersten Schale (12) zusammengebaut wird,
- einen zweiten Schritt des Zusammenbaus des Stromwandlers (2), in dem der Magnetkreis (4) des Stromwandlers (2) auf das Zwischenelement (8) überlagert wird,
- einen dritten Schritt des Zusammenbaus einer zweiten Schale (13), in dem die zweite Schale (13) mit der erste Schale (12) zusammengebaut wird, um das die kalibrierte Untereinheit (11) und den Stromwandler (2) umfassende Gehäuse (14) zusammenzubauen.

## Claims

1. Method for calibrating a current sensor (1) for an electrical switchgear, said current sensor (1) comprising at least one current transformer (2) and a Rogowski coil (3) having a rotational axis (A1), the current transformer (2) comprising at least one magnetic circuit (4) on which the Rogowski coil (3) is able to be superposed so as to be able to be passed through by a conductor (L),
said calibration method being **characterized in that** it comprises at least:
- a step of measuring the sensitivity of the Rogowski coil (3) during which a current (I) is applied to said conductor (L) so as to generate a non-uniform magnetic field and a voltage measurement at the output of the Rogowski coil (3) is taken as a function of the position (P) of the Rogowski coil (3) relative to the position of the magnetic circuit (4) about the rotational axis (A1),
- a step of selecting the position (P) of the Rogowski coil (3) during which a so-called selected position (PS) of the Rogowski coil (3) relative to said position of the magnetic circuit (4) about the rotational axis (A1) is selected as a function of the sensitivity measurements carried out during said step of measuring the sensitivity of the Rogowski coil (3) such that, at the so-called selected position (PS), the sensitivity is equal to a predetermined target sensitivity.

2. Method for calibrating a current sensor (1) for an electrical switchgear according to Claim 1, **characterized in that** it further comprises a step of immobilizing the so-called selected position (PS) of the Rogowski coil (3) during which the so-called selected position (PS) of the Rogowski coil (3), which is selected at the end of said step of selecting the position (P) of the Rogowski coil (3), is immobilized by immobilization means (5) relative to said position of the magnetic circuit (4).

3. Method for calibrating a current sensor (1) for an electrical switchgear according to either of Claims 1 and 2, **characterized in that** during said step of measuring the sensitivity of the Rogowski coil (3), the Rogowski coil (3) is rotated about the rotational axis (A1) by a rotating element relative to the magnetic circuit (4) of the current transformer (2) or to a reference magnetic circuit of a reference current transformer which is stationary, or the magnetic circuit (4) or the reference magnetic circuit is rotated about the rotational axis (A1) by said rotating element (6) relative to the Rogowski coil (3) which is stationary.

4. Method for calibrating a current sensor (1) for an electrical switchgear according to Claim 3, **characterized in that** during said step of measuring the sensitivity of the Rogowski coil (3), the voltage measurement (U) at the output of the Rogowski coil (3) and the rotation about the rotational axis (A1) of the Rogowski coil (3) or of the magnetic circuit (4) or of the reference magnetic circuit are carried out simultaneously.

5. Method for calibrating a current sensor (1) for an electrical switchgear according to any one of Claims 1 to 4, **characterized in that** said step of measuring the sensitivity of the Rogowski coil (3) is carried out for angular positions (P) of the Rogowski coil (3) relative to a reference position of the magnetic circuit (4) which are comprised between 0 degrees and 360 degrees.

6. Installation for calibrating a current sensor (1) for an electrical switchgear, said current sensor (1) comprising at least one current transformer (2) or a reference current transformer and a Rogowski coil (3) having a rotational axis (A1), the current transformer (2) comprising at least one magnetic circuit (4) or the reference current transformer comprising at least one reference magnetic circuit, on which said one magnetic circuit (4) or reference magnetic circuit the Rogowski coil (3) is able to be superposed so as to be able to be passed through by a conductor (L), and for implementing the calibration method according to any one of Claims 3 to 5,
said installation being **characterized in that** it comprises at least:
- a rotating element arranged to rotate at least the Rogowski coil (3) or at least the magnetic circuit (4) or the reference magnetic circuit about the rotational axis (A1),
- a blocking element (7) arranged to block the rotation about the rotational axis (A1) of the Rogowski coil (3) or of the magnetic circuit (4) or of the reference magnetic circuit respectively during the rotation of the magnetic circuit (4) or of the reference magnetic circuit or during the rotation of the Rogowski coil (3) by said rotating element (6).

7. Current sensor (1) for an electrical switchgear, said current sensor (1) comprising at least one current transformer (2) and a Rogowski coil (3) having a rotational axis (A1), the current transformer (2) comprising at least one magnetic circuit (4) on which the Rogowski coil (3) is able to be superposed so as to be able to be passed through by a conductor (L), said current sensor (1) being **characterized in that** it comprises immobilization means (5) arranged to immobilize the so-called selected position (PS) of the Rogowski coil (3) relative to said position of the magnetic circuit (4), which so-called selected position is selected at the end of said step of selecting the position (P) of the Rogowski coil (3) of the method for calibrating a current sensor (1) for an electrical switchgear according to any one of Claims 1 to 5.

8. Current sensor for an electrical switchgear according to Claim 7, **characterized in that** it comprises bonding means or equivalent fixing or assembling means situated between said magnetic circuit (4) and the Rogowski coil (3) in order to fix the Rogowski coil (3) in the so-called selected position (PS) on the magnetic circuit (4) of the current transformer (2).

9. Current sensor for an electrical switchgear according to Claim 7, **characterized in that** it comprises a housing comprising a first casing and a second casing, the first casing having a first reception area having a shape that is complementary to that at least of the Rogowski coil (3) and receives the Rogowski coil (3), and the second casing having a second reception area having a shape that is complementary to that at least of the current transformer (2) and receives said current transformer (2), and **in that** it comprises bonding means or equivalent fixing or assembling means situated between the Rogowski coil (3) and the second casing in order to fix the Rogowski coil (3) in the so-called selected position (PS) relative to the magnetic circuit (4) of the current transformer (2).

10. Current sensor (1) for an electrical switchgear according to Claim 7, **characterized in that** it comprises a housing comprising a first casing and a second casing, the first casing having a first reception area having a shape that is complementary to that at least of the Rogowski coil (3) and receives the Rogowski coil, and the second casing having a second reception area having a shape that is complementary to that at least of the current transformer (2) and receives said current transformer (2), and **in that** it comprises bonding means or equivalent fixing or assembling means situated between the Rogowski coil (3) and the first casing in order to fix the Rogowski coil (3) in the so-called selected position (PS) relative to the magnetic circuit (4) of the current transformer.

11. Current sensor (1) for an electrical switchgear according to Claim 7, **characterized in that** it comprises an intermediate element (8), arranged to be disposed between said magnetic circuit (4) and the Rogowski coil (3), on which the Rogowski coil (3) is fixed in the so-called selected position (PS) by fixing means (9) and **in that** said intermediate element (8) comprises at least one fool-proofing mechanism (10, 21) so that it can be assembled at least with said magnetic circuit (4) of the current transformer (2), said intermediate element (8) fixed to the Rogowski coil (3) forming a calibrated sub-assembly (11).

12. Method for assembling a current sensor (1) for an electrical switchgear according to Claim 11, comprising at least one housing (14) comprising a first casing (12) and a second casing (13), the first casing (12) having a first reception area (15) having a shape that is complementary to that at least of the Rogowski coil (3) and receives the Rogowski coil (3), and the second casing (13) having a second reception area having a shape that is complementary to that at least of the current transformer (2) and receives said current transformer (2), said assembling method being **characterized in that** it comprises at least:
- a first step of assembling said calibrated sub-assembly (11) during which said calibrated sub-assembly (11) is assembled with the first casing (12),
- a second step of assembling the current transformer (2) during which the magnetic circuit (4) of the current transformer (2) is superposed on said intermediate element (8),
- a third step of assembling a second casing (13) during which the second casing (13) is assembled to the first casing (12) so as to assemble the housing (14) containing the calibrated sub-assembly (11) and the current transformer (2).
